# EUROPÄISCHE PATENTSCHRIFT

(11) **EP 1 718 139 B1**
(45) Veröffentlichungstag und Bekanntmachung des Hinweises auf die Patenterteilung: **20.10.2010**
(21) Anmeldenummer: 06006212.2
(22) Anmeldetag: 25.03.2006
(51) Int. Cl.: H05K 3/40

(54) **Verfahren zum Herstellen einer Leiterplatte mit Mikrovias und solch eine Leiterplatte**
Method for manufacturing a circuit board with microvias and such a circuit board
Procédé de fabrication d'une carte de circuits avec des microvias et une telle carte de circuits

(30) Priorität: 14.04.2005 DE 102005018274
(43) Veröffentlichungstag der Anmeldung: 02.11.2006
(73) Patentinhaber: Würth Elektronik Schopfheim GmbH & Co. KG, 79650 Schopfheim (DE)
(72) Erfinder:
(74) Vertreter: Patentanwälte Ruff, Wilhelm, Beier, Dauster & Partner

(56) Entgegenhaltungen:
- US-A- 5 450 290
- US-A- 5 766 670
- US-A1- 2002 179 335

## Beschreibung

Die Erfindung betrifft eine Leiterplatte und ein Verfahren zu ihrer Herstellung, insbesondere ein Verfahren zur Herstellung von Verbindungsstellen auf einer Leiterplatte.

Um eine Verbindung zwischen anzulötenden Bauteilen und den Leiterbahnen einer Leiterplatte herzustellen, die ja innerhalb der Leiterplatte liegen können, sind Mikrovias bekannt. Diese werden mit Hilfe von Lasern in die Leiterplatten eingebracht. Anschließend werden sie mit einem Lötmaterial ausgefüllt, an dessen Oberfläche die Bauteile angelötet werden.

Heutige Produktionsverfahren ermöglichen es, Mikrovias über eine spezielle Galvanik mit Kupfer zu verschließen. Der Nachteil dieses Verfahrens liegt darin, dass es teuer ist, und in Verbindung mit durchgehenden Mikrovias nur bedingt angewendet werden kann.

Weiterhin ist es bekannt, die Mikrovias galvanisch mit Kupfer vorzuverstärken und anschließend mit einem Polymer zu füllen. Die elektrische Leitung wird in erster Linie durch das Kupfer erzeugt. Hierbei besteht jedoch das Problem, dass es häufig Lufteinschlüsse gibt, die stören.

Ebenfalls bekannt ist es, die Mikrovias ohne galvanische Vorverstärkung mit einem Silberleitpolymer zu füllen. Die elektrische Leitung wird direkt über das Silberleitpolymer erzeugt.

### (Beginn einer Einfügung)

Bei einem bekannten Verfahren zum Füllen schmaler Löcher mit elektrisch leitendem Material wird zwischen der Oberseite und der Unterseite der Leiterplatte eine große Druckdifferenz hergestellt. Dadurch können die durchgehenden Bohrungen vollständig mit dem leitenden Material gefüllt werden (US 2002/179 335).

Weiterhin ist es bekannt, durchgehende Löcher in herkömmlicher Weise mit Kupfer zu beschichten (US 5 450 290).

### (Ende der Einfügung)

Der Erfindung liegt die Aufgabe zu Grunde, ein Verfahren und eine Leiterplatte vorzuschlagen, um mit geringem Aufwand Leiterplattenverbindungsstellen herzustellen, die bessere Möglichkeiten bieten.

Zur Lösung dieser Aufgabe schlägt die Erfindung ein Verfahren mit den im Anspruch 1 genannten Merkmalen sowie eine Leiterplatte mit den im Anspruch 7 genannten Merkmalen vor. Weiterbildungen der Erfindung sind Gegenstand von Unteransprüchen.

Die Erfindung schlägt also vor, in die Mikrovias, flüssiges Metall auf- oder einzudosieren, in einer vorher festgelegten Menge. Nach dem Aushärten des Metalls oder der Metalllegierung weist das jeweilige Mikrovia sowohl eine elektrische Verbindung, als auch ein Lotdepot als auch eine Endoberfläche aus einem bestimmten vorher ausgewählten Metall auf. Dadurch wird die Endoberfläche und das Lotdepot für die weitere Verarbeitung im Bestückungsprozess gleichzeitig hergestellt.

Die Mikrovias können in Weiterbildung der Erfindung vorher galvanisch metallisiert sein, zur Bildung einer Vorverstärkung.

Das Einfüllen des flüssigen Metalls oder der Legierung bzw. das Benetzen damit geschieht vorzugsweise in fertig strukturiertem Zustand der Leiterplatte.

Insbesondere wird zum Benetzen, Einfüllen und Eindosieren des flüssigen Metalls eine Nanodosierung verwendet werden, ein Verfahren, das vom Institut of Microsystem Technologie der Universität Freiburg entwickelt und in einem Vortrag im Rahmen einer Messe vorgestellt wurde. Dieses Verfahren ermöglicht die Erzeugung feinster Tropfen in einem freien Strahl.

Bei diesem Verfahren, das von der Erfindung verwendet wird, wird das Metall mittels kleiner Tropfen dosiert, die mit einem Dispenser in regelbaren Mengen abgegeben werden.

Es wurde bereits erwähnt, dass die Mikrovias nicht nur mit einem Metall, sondern auch mit einer Metalllegierung benetzt bzw. gefüllt werden können. Dies kann auch bei einer Leiterplatte kombiniert werden, da das Befüllen der Mikrovias einzeln erfolgen kann. Es können auch Metalle und verschiedene Metalllegierungen kombiniert werden.

Ebenfalls möglich ist es, Mikrovias mit einer Dispersion zu füllen, beispielsweise einer speziellen Carbonwiderstandspaste, um auf diese Weise Widerstände zu bilden.

Es ist mit dem von der Erfindung vorgeschlagenen Verfahren zum Befüllen der Mikrovias möglich, die Schichtdicke an die speziellen Erfordernisse sowohl der Bauteile als auch des Anbringungsverfahrens der Bauteile anzupassen. Natürlich ist es auch möglich, ein für den speziellen Anwendungsfall besonders geeignetes Metall oder eine Metalllegierung zu verwenden.

Die von der Erfindung vorgeschlagene Leiterplatte enthält Mikrovias, die galvanisch metallisiert und mit einem im flüssigen Zustand eindosierten Metall gefüllt sind, das in erstarrtem Zustand ein Lotdepot und eine Endoberfläche bildet. Die Mikrovias können beispielsweise mit einer Dispersion gefüllt sein.

Durch das Eindosieren mit Hilfe kleinster Flüssigkeitstropfen wird es möglich, was ein weiteres Merkmal der Erfindung bilden kann, die Mikrovias vollständig zu füllen, so dass es keine Lufteinschlüsse mehr gibt.

Die Schichtdicke des in den Mikrovias enthaltenen Metalls oder der Metalllegierung kann an die anzulötenden Bauteile angepasst sein, oder auch an das Verfahren, mit dem die anzulötenden Bauteilen angelötet werden.

Weitere Merkmale, Einzelheiten und Vorzüge der Erfindung ergeben sich aus den Ansprüchen und der Zusammenfassung, deren beider Wortlaut durch Bezugnahme zum Inhalt der Beschreibung gemacht wird, der folgenden Beschreibung einer bevorzugten Ausführungsform der Erfindung sowie anhand der Zeichnung. Hierbei zeigen:

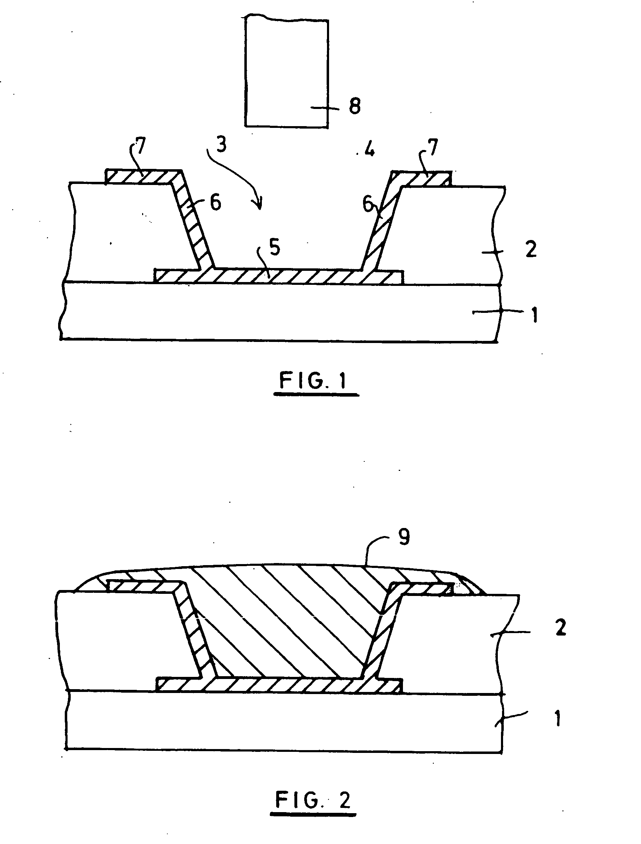

- Figur 1: einen schematischen Querschnitt durch ein Mikrovia und
- Figur 2: den Querschnitt durch das Mikrovia nach Befüllen mit dem flüssigen Metall.

In einer Leiterplatte mit zwei Lagen 1, 2 ist ein Mikrovia 3 gebohrt worden und anschließend mit einer galvanischen Vorverstärkung 4 versehen worden. Diese galvanische Vorverstärkung 4 bildet einen Boden 5 und eine sich kegelstumpfförmig erweiternde Seitenwand 6. Auf der Oberseite der Leiterplatte 1, 2 bildet die Vorverstärkung 4 dann einen umlaufenden Flansch 7.

Oberhalb des Mikrovias ist das Abgabeende 8 eines Dispensers dargestellt, mit dessen Hilfe einzelne Tropfen eines flüssigen Metalls abgegeben werden können. Diese Tropfen des flüssigen Metalls werden in die Vorverstärkung 4 des Mikrovias eindosiert. Da die Tropfen aus flüssigem Metall noch im flüssigen Zustand in die Vertiefung gelangen, können sie diese vollständig ausfüllen, bevor sie erstarren. Dadurch ist sichergestellt, dass keine Lufteinschlüsse mehr vorhanden sind. Die Eindosierung wird solange fortgesetzt, bis eine Endoberfläche 9 entstanden ist, die gegenüber der Oberseite der Leiterplatte 1, 2 beziehungsweise gegenüber der Oberseite des Flanschs 7 eine bestimmte Schichtdicke aufweist.

Nach dem Erkalten ist in dem Mikrovia ein Lotdepot und eine Endoberfläche 9 vorhanden, die zur Verbindung mit den anzubringenden Bauteilen dient.

## Patentansprüche

1. Verfahren zum Herstellen von Leiterplatten mit Verbindungsstellen, bei dem
1.1 in eine Leiterplatte (1, 2) als Lötflächen Mikrovias eingebracht werden,
1.2 auf die vorgesehenen Lötflächen zur Bildung des Lotdepots und der Endoberfläche (9) flüssiges Metall aufdosiert wird,
**dadurch gekennzeichnet, dass**
1.3 das flüssige Metall mittels kleiner Tropfen in Nanogröße dosiert wird, die
1.4 mit einem Dispenser in regelbaren Mengen abgegeben werden.

2. Verfahren nach Anspruch 1 bei dem die und/oder die Mikrovias vorher galvanisch metallisiert werden.

3. Verfahren nach Anspruch 1, bei dem die Mikrovias in fertig strukturiertem Zustand der Leiterplatte mit dem Metall versehen bzw. gefüllt werden.

4. Verfahren nach einem der vorhergehenden Ansprüche, bei dem die Mikrovias mit einer Metalllegierung versehen werden.

5. Verfahren nach einem der vorhergehenden Ansprüche, bei dem die Mikrovias mit einer Dispersion gefüllt werden.

6. Verfahren nach einem der vorhergehenden Ansprüche, bei dem die Schichtdicke des in die Mikrovias dosierten Metalls an die anzulötenden Bauteile angepasst wird.

7. Leiterplatte mit Verbindungsstellen, mit
7.1 Lötflächen, die
7.2 von Mikrovias gebildet sind,
**dadurch gekennzeichnet, dass**
7.3 die Mikrovias mit in flüssigen Zustand tröpfchenweise in Nanogröße eindosiertem Metall gefüllt sind,
7.4 das in erstarrtem Zustand ein Lotdepot und eine Endoberfläche (9) bildet.

8. Leiterplatte nach Anspruch 7, bei der die Mikrovias mit einer Dispersion gefüllt sind.

9. Leiterplatte nach Anspruch 7 oder 8, bei der die Mikrovias vor dem Eindosieren des Metalls galvanisch metallisiert sind.

10. Leiterplatte nach Anspruch 7 bis 9, bei der die Mikrovias vollständig gefüllt sind.

11. Leiterplatte nach einem der Ansprüche 7 bis 10, bei der die Schichtdicke des in die Mikrovias eingefüllten
Metalls an die anzubringenden Bauteile angepasst ist.

12. Leiterplatte nach einem der Ansprüche 7 bis 11, bei der mindestens ein Mikrovia mit einer Carbonwiderstandspaste gefüllt ist.

## Claims

1. Method for producing printed circuit boards with connection locations wherein
1.1 microvias are introduced into a printed circuit board (1, 2) as soldering areas,
1.2 liquid metal is metered onto the soldering areas provided for forming the solder deposit and the end surface (9)
**characterized in that**
1.3 the liquid metal is metered by means of small drops of nanosize which
1.4 are released in regulable amounts by means of a dispenser.

2. Method according to Claim 1, wherein the microvias are electrolytically metallized beforehand.

3. Method according to Claim 1, wherein the microvias are provided or filled with the metal in the finished structured state of the printed circuit board.

4. Method according to any of the preceding claims, wherein the microvias are provided with a metal alloy.

5. Method according to any of the preceding claims, wherein the microvias are filled with a dispersion.

6. Method according to any of the preceding claims, wherein the layer thickness of the metal metered into the microvias is adapted to the components to be soldered on.

7. Printed circuit board with connection locations, comprising
7.1 soldering areas which
7.2 are formed by microvias,
**characterized in that**
7.3 the microvias are filled with metal introduced by metering in a liquid state in the manner of droplets of nanosize,
7.4 which metal, in a solidified state forms a solder deposit and an end surface (9).

8. Printed circuit board according to Claim 7, wherein the microvias are filled with a dispersion.

9. Printed circuit board according to Claim 7 or 8, wherein the microvias are electrolytically metallized before the metal is introduced by metering.

10. Printed circuit board according to Claims 7 to 9, wherein the microvias are completely filled.

11. Printed circuit board according to any of Claims 7 to 10, wherein the layer thickness of the metal filled into the microvias is adapted to the components to be fitted.

12. Printed circuit board according to any of Claims 7 to 11, wherein at least one microvia is filled with a carbon resistor paste.

## Revendications

1. Procédé de fabrication de circuits imprimés muni de points de liaison, selon lequel
1.1 des microvias sont pratiquées dans un circuit imprimé (1, 2) en tant que surfaces à braser,
1.2 un métal liquide est appliqué de manière dosée sur les surfaces à braser prévues en vue de former le réservoir de brasure et la surface finale (9),
**caractérisé en ce que**
1.3 le métal liquide est dosé au moyen de petites gouttes de nanodimension qui
1.4 sont délivrées en quantités réglables avec un distributeur.

2. Procédé selon la revendication 1, selon lequel les microvias sont préalablement métallisées galvaniquement.

3. Procédé selon la revendication 1, selon lequel, dans l'état structuré fini du circuit imprimé, les microvias sont munies ou remplies de métal.

4. Procédé selon l'une des revendications précédentes, selon lequel les microvias sont munies d'un alliage métallique.

5. Procédé selon l'une des revendications précédentes, selon lequel les microvias sont remplies avec une dispersion.

6. Procédé selon l'une des revendications précédentes, selon lequel l'épaisseur de la couche du métal dosé dans les microvias est adaptée aux composants à monter par brasage.

7. Circuit imprimé muni de points de liaison, comprenant
7.1 des surfaces à braser qui
7.2 sont formées par des microvias,
**caractérisé en ce que**
7.3 les microvias sont remplies de métal qui est dosé à l'état liquide au moyen de petites gouttes de nanodimension,
7.4 qui forme, à l'état solidifié, un réservoir de brasure et une surface finale (9).

8. Circuit imprimé selon la revendication 7, dans lequel les microvias sont remplis avec une dispersion.

9. Circuit imprimé selon la revendication 7 ou 8, dans lequel les microvias sont métallisées galvaniquement avant l'application dosée du métal.

10. Circuit imprimé selon les revendications 7 à 9, dans lequel les microvias sont entièrement remplies.

11. Circuit imprimé selon l'une des revendications 7 à 10, dans lequel l'épaisseur de la couche du métal dosée dans les microvias est adaptée aux composants à monter.

12. Circuit imprimé selon l'une des revendications 7 à 11, dans lequel au moins une microvia est remplie d'une pâte résistive au carbone.
